# EUROPEAN PATENT SPECIFICATION

(11) **EP 2 375 484 B1**
(45) Date of publication and mention of the grant of the patent: **07.05.2014**
(21) Application number: 11250398.2
(22) Date of filing: 29.03.2011
(51) Int. Cl.: H01M 8/04

(54) **Operating method of fuel cell system**
Betriebsverfahren eines Brennstoffzellensystems
Procédé de fonctionnement d'un système de pile à combustible

(30) Priority: 01.04.2010 US 320261 P; 28.02.2011 US 37217
(43) Date of publication of application: 12.10.2011
(73) Proprietor: Samsung SDI Co., Ltd., Gyeonggi-do (KR)
(72) Inventor: Park, Jung-Kurn, Gyeonggi-do (KR); Na, Young-Seung, Gyeonggi-do (KR); Cho, Hye-Jung, Gyeonggi-do (KR); Hu, Lei, Gyeonggi-do (KR)
(74) Representative: Mounteney, Simon James

(56) References cited:
- EP-A1- 2 045 863
- JP-A- 2004 193 113
- JP-A- 2009 163 940
- US-A1- 2005 040 786

## Description

### (a) Field of the Invention

The present invention relates to an operating method of a fuel cell system and more particularly, to a fuel cell system with an improved fuel supplying method and an operating method of the fuel cell system.

### (b) Description of the Related Art

A fuel cell, as a device electrochemically generating power by using fuel (hydrogen or reformed gas) and oxidant (oxygen or air), directly converts the fuel (hydrogen or reformed gas) and the oxidant (oxygen or air), which are continuously supplied from the outside, into electrical energy by the electrochemical reaction.

An example of the oxidant of the fuel cell may use pure oxygen or air containing a large amount of oxygen and an example of the fuel may use pure hydrogen or fuel containing a large amount of hydrogen generated by reforming hydrocarboneous fuel (LNG, LPG, CH₃OH).

It is very important to supply a uniform amount of fuel in the fuel cell system. In the 20W direct methanol fuel cell system, when a flux is changed by 0.03cc/min, there is a difference in fuel efficiency by about 10%. The change in the flux changes operation states such as operation concentration, operating temperature, operating pressure, etc. to deteriorate the stability of the fuel cell stack and reduce the life-span of the fuel cell.

As a method for finely controlling a flux, a method using a precision concentration sensor and a high precision pump has been the most commonly adopted.

However, the precision concentration sensor cannot precisely measure the concentration when temperature is changed. The method for correcting concentration sensor according to the change in temperature has been used. However, it is difficult for the method to precisely correct concentration according to the change in ambient temperature since the temperature sensor is affected by heat generated from the fuel cell stack.

In addition, when the fuel cell system is user for a long time, the zero point of the precision concentration sensor is changed, thereby giving rise to error in the measured concentration.

Further, a low flux and high precision pump is vulnerable to foreign matters introduced thereinto and has severely deteriorated performance and weak durability when it is operated for a long time. Since the low flux and high precision pump is generally manufactured to be used in a laboratory, its durability becomes weak when it is used in a place where fuel with many foreign matters is supplied for a long time.

The above information disclosed in this Background section is only for enhancement of understanding of the background of the invention and therefore it may contain information that does not form the prior art that is already known in this country to a person of ordinary skill in the art.

### SUMMARY OF THE INVENTION

The present invention has been made in an effort to provide an operating method of a fuel cell stack capable of easily supplying fuel to the stack without a concentration sensor.

An embodiment of the present invention provides an operating method of a fuel cell system, including: operation starting step without supplying fuel generating electricity at a predetermined voltage while stopping the supply of fuel; a voltage reducing step of reducing output voltage to targeted voltage; a current increasing rate measuring step of comparing the increasing rate of current with the increasing rate of targeted current; a fuel supply starting step of supplying fuel to the fuel cell stack; and a current following fuel supplying step of controlling fuel concentration and supplying it to be reached to the targeted current.

According to an embodiment of the present invention, a precision flux of fuel can be supplied to the fuel cell stack by using the resistors and the pump regardless of the change in pressure.

According to an aspect of the invention, there is provided a fuel cell system comprising a fuel tank, a fuel cell stack and a controller, wherein: the fuel cell system is arranged to generate electrical power in the fuel cell stack while not fuel supplying fuel from the fuel tank to the fuel cell stack so as to reduce an output voltage of the fuel cell stack and increase an output current of the fuel cell stack; the controller is arranged to monitor the output current of the fuel cell stack; the controller is arranged to start the supply of fuel from the fuel tank to the fuel stack when the output current is above a threshold current or when a rate of increase of the output current is below a threshold rate; and the controller is arranged to control the supply of fuel from the fuel tank to the fuel stack to direct the output current towards a target current level.

The controller may be arranged such that supply of fuel to the fuel stack comprises periodically starting and stopping the supply of fuel to the fuel cell stack.

The fuel cell system may arranged to continue generating electrical power in the fuel cell stack while not supplying fuel to the fuel cell stack until the output voltage reaches a target voltage.

The fuel cell system may arranged such that the supply of fuel to the fuel stack is started when a rate of increase of the output current is below the threshold rate, the threshold rate being between 0 A/s and -0.5 A/s.

The controller may be arranged to control the supply of fuel to the fuel stack is while maintaining the output voltage to be constant at a target voltage level.

The fuel cell system may comprise a temperature sensor arranged to measure the temperature of the fuel cell stack to determine whether the temperature of the fuel cell stack is higher than a threshold temperature; when the temperature of the fuel cell stack is higher than the threshold temperature, the controller may be arranged to reduce the target voltage level to a second target voltage level and then to control the supply of fuel to the fuel cell stack to direct the output current towards the target current level, while maintaining the output voltage of the fuel cell stack to be constant at the second target voltage level. The threshold temperature may be between 2% and 10% greater than a reference operating temperature.

The fuel cell system may comprise a cooling fan adapted to cool the fuel cell stack; wherein the fuel cell system is arranged to measure an operating power of the cooling fan to determine whether the operating power of the cooling fan is higher than a threshold power; when the operating power of the cooling fan is higher than the threshold power, the controller may be arranged to reduce the target voltage level to a second target voltage level and then to control the supply of fuel to the fuel cell stack to direct the output current towards the target current level, while maintaining the output voltage of the fuel cell stack to be constant at the second target voltage level. The threshold power may be set to be a power higher by 5% to 20% than a reference operating power, wherein optionally the reference operating power is 70% of a maximum use power of the fan.

According to an aspect of the invention, there is provided a method of controlling a fuel cell system comprising a fuel cell stack, and a controller connected to a load, the method comprising in order: generating electrical power in the fuel cell stack while not supplying fuel to the fuel cell stack so as to reduce an output voltage of the fuel cell stack and increase an output current of the fuel cell stack; monitoring the output current of the fuel cell stack; starting the supply of fuel to the fuel stack when the output current is above a threshold current or when a rate of increase of the output current is below a threshold rate; and controlling supply of fuel to the fuel stack to direct the output current towards a target current level.

Controlling supply of fuel to the fuel stack may comprise periodically starting and stopping the supply of fuel.

In some embodiments, the generating of electrical power in the fuel cell stack while not supplying fuel to the fuel cell stack is continued until the output voltage reaches a target voltage.

In some embodiments, controlling supply of fuel to the fuel stack is carried out while maintaining the output voltage to be constant at a target voltage level.

In some embodiments, the method may further comprise: measuring the temperature of the fuel cell stack to determine whether the temperature of the fuel cell stack is higher than a threshold temperature; when the temperature of the fuel cell stack is higher than the threshold temperature, reducing the target voltage level to a second target voltage level; controlling the supply of fuel to the fuel cell stack to direct the output current towards the target current level, while maintaining the output voltage of the fuel cell stack to be constant at the second target voltage level. The threshold temperature may be between 2% and 10% greater than a reference operating temperature.

In some embodiments, the method may further comprise using a cooling fan adapted to cool the fuel cell stack, the method further comprising: measuring an operating power of the cooling fan to determine whether the operating power of the cooling fan is higher than a threshold power; when the operating power of the cooling fan is higher than the threshold power, reducing the target voltage level to a second target voltage level; controlling the supply of fuel to the fuel cell stack to direct the output current towards the target current level, while maintaining the output voltage of the fuel cell stack to be constant at the second target voltage level.

The threshold power may be set to be a power higher by 5% to 20% than a reference operating power, wherein optionally the reference operating power is 70% of a maximum use power of the fan.

According to another aspect of the invention, there is provided a method of controlling a fuel cell system comprising a fuel cell stack, the method comprising: controlling supply of fuel to the fuel cell stack to direct an output current of the fuel cell stack towards a target current level, while maintaining an output voltage of the fuel cell stack to be constant at a first target voltage level; measuring the temperature of the fuel cell stack to determine whether the temperature of the fuel cell stack is higher than a threshold temperature; when the temperature of the fuel cell stack is higher than the threshold temperature, reducing the target voltage level from the first target voltage level to a second target voltage level; controlling the supply of fuel to the fuel cell stack to direct the output current towards the target current level, while maintaining the output voltage of the fuel cell stack to be constant at the second target voltage level.

The method may comprise controlling the supply of fuel to the fuel stack by the controller by periodically starting and stopping the supply of fuel to the fuel cell stack to direct the output current towards the target current level.

According to another aspect of the invention, there is provided a method of controlling a fuel cell system comprising a fuel cell stack and a cooling fan adapted to cool the fuel cell stack, the method comprising: controlling supply of fuel to the fuel cell stack to direct an output current of the fuel cell stack towards a target current level, while maintaining an output voltage of the fuel cell stack to be constant at a first target voltage level; measuring an operating power of the cooling fan to determine whether the operating power of the cooling fan is higher than a threshold power; when the operating power of the cooling fan is higher than the threshold power, reducing the target voltage level from the first target voltage level to a second target voltage level; controlling the supply of fuel to the fuel cell stack to direct the output current towards the target current level, while maintaining the output voltage of the fuel cell stack to be constant at the second target voltage level.

The method may comprise controlling the supply of fuel to the fuel stack by the controller by periodically starting and stopping the supply of fuel to the fuel cell stack to direct the output current towards the target current level.

According to another aspect of the invention, there is provided a method of controlling a fuel cell system comprising a fuel cell stack, the method comprising: periodically starting and stopping supply of fuel to the fuel cell stack to direct an output current of the fuel cell stack towards a target current level, while maintaining an output voltage of the fuel cell stack to be constant at a target voltage level.

### BRIEF DESCRIPTION OF THE DRAWINGS

FIG. 1 is a schematic diagram of a fuel cell system according to a first embodiment of the present invention;
FIG. 2 is a flowchart showing an operating method of a fuel cell system according to the first embodiment of the present invention;
FIG. 3 is a graph of voltage and current against time according to the method of operating a fuel cell system shown in FIG. 2.
FIG. 4 is a schematic configuration diagram of a fuel cell system according to a second embodiment of the present invention;
FIG. 5 is a flowchart showing an operating method of the fuel cell system according to the second embodiment of the present invention;
FIG. 6 is a graph showing the voltage, current, power, fuel concentration of the stack according to the operating method of the fuel cell system according to the first embodiment and second embodiment of the present invention;
FIG. 7 is a graph showing the current and fuel concentration according to the operating method of the fuel cell system according to the first embodiment and second embodiment of the present invention;
FIG. 8 is a graph showing a stack temperature, an anode temperature, and an external temperature according to the operating method of the fuel cell system according to the first embodiment and exemplary embodiment of the present invention;
FIG. 9 is a graph showing the power, voltage, current, and fuel concentration of the stack when restarting the operation by the operating method of the fuel cell system according to the first embodiment and second embodiment of the present invention;
FIG. 10 is a graph showing the current and fuel concentration of the stack when restarting the operation by the operating method of the fuel cell system according to the first embodiment and second embodiment of the present invention;
FIG. 11 is a schematic configuration diagram of the fuel cell system according to a third embodiment of the present invention; and
FIG. 12 is a flowchart for explaining the operating method of the fuel cell system according to the third embodiment of the present invention.

### DETAILED DESCRIPTION OF THE EMBODIMENTS

The present invention will be described more fully hereinafter with reference to the accompanying drawings, in which exemplary embodiments of the invention are shown. However, As those skilled in the art would realize, the described embodiments may be modified in various different ways, all without departing from the spirit or scope of the present invention.

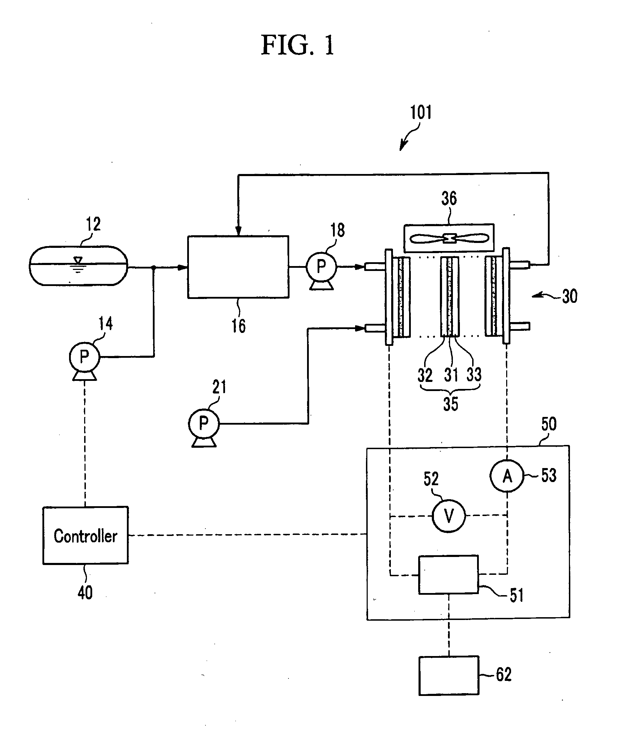

FIG. 1 is a schematic diagram of a fuel cell system according to a first embodiment of the present invention.

Referring to FIG. 1, a fuel cell system 101 according to the present embodiment may adopt a direct methanol fuel cell scheme that generates electrical energy by the direct reaction of methanol and oxygen.

However, the embodiments of the present invention are not limited thereto. The fuel cell system according to the present embodiment may be configured in a direct oxidation fuel cell manner that reacts liquid and gas fuel containing hydrogen such as ethanol, LPG, LNG, gasoline, butane gas, etc. with oxygen. In addition, the fuel cell system may be configured in a polymer electrode membrane fuel cell (PEMFC) that reforms fuel into hydrogen-rich reformed gas and uses it.

The fuel used in the fuel cell system 101 is generally referred to as hydrocarboneous fuel composed of a liquid or gas state such as methanol, ethanol, natural gas, LPG, etc.

However, the fuel cell system 101 may use air as oxidant reacting with hydrogen and oxygen gas that is stored in a separate storage unit.

The fuel cell system 101 according to the present embodiment includes a fuel cell stack 30 that generates power using fuel and oxidant, a fuel tank 12 that supplies fuel to the fuel cell stack 30, an oxidant pump 21 that supplies oxidant for generating electricity to the fuel cell stack 30, and a mixer 16 that is installed between the fuel cell stack 30 and the fuel tank 12.

The first fuel pump is connected to the fuel tank 12 to discharge the liquid fuel stored in the fuel tank 12 from the fuel tank 12 by a predetermined pumping force. In the present embodiment, the fuel stored in the fuel tank 12 may be composed of methanol. Meanwhile, the oxidant pump 21 serves to supply air to the fuel cell stack 30.

The mixer 16 mixes the fuel supplied from the fuel tank 12 and water drawn from the fuel cell through a withdraw pipe and supplies the mixture to the fuel cell stack 30. A second fuel pump 18, which supplies the fuel stored in the mixer 16 to the fuel cell stack 30, is installed between the mixer 16 and the fuel cell stack 30.

The fuel cell stack 30 includes a plurality of electric generators 35 that induce the oxidation/reduction reaction of fuel and oxidant to generate electrical energy.

Each electric generator 35 comprises a unit cell that generates electricity and includes a membrane-electrode assembly 31 (MEA) that oxidizes/reduces fuel and oxygen in oxidant and separators 32 and 33 (referred to as a bipolar plate in the field) that supplies fuel and oxidant to the membrane electrode assembly 31.

The electric generator 35 has a structure that each of the separators 32 and 33 is disposed at both sides of the membrane-electrode assembly 31. The separators 32 and 33 is closely attached to each other, putting the membrane-electrode assembly 31 therebetween, thereby forming a fuel passage and an air passage at each of both sides of the membrane-electrode assembly 31. The fuel passage is disposed at an anode side of the membrane-electrode assembly 31 and the air passage is disposed at a cathode side of the membrane-electrode assembly 31. As a result of the electrolyte membrane protons generated from the anode move to the cathode to be coupled with oxygen of the cathode electrode, thereby making it possible to achieve ion exchange generating water.

As a result, hydrogen is decomposed into electrons and protons (hydrogen ions) in the anode by the oxidation reaction. The protons move to the cathode electrode through the electrolyte membrane and the electron moves to the cathode of the adjacent membrane-electrode assembly 31 through the separator 33, not moving through the electrolyte membrane. At this time, current is generated by the flow of electrons. In addition, moisture is generated in the cathode by the reduction reaction of the moved proton and electron and oxygen.

The fuel cell system 101 configures the fuel cell stack 30 by continuously disposing the plurality of electric generators 35. One side of the fuel cell stack 30 is provided with a cooling fan 36 for cooling the fuel cell stack 30. Since a large amount of heat is generated during the electricity generation of the fuel cell stack 30, the cooling fan 36 supplies air to the fuel cell stack 30 to lower the temperature of the fuel cell stack 30.

As the fuel cell stack 30 according to the present embodiment, a 30W fuel cell stack 30 that is small capacity will be described as an example. However, this is only an example description and therefore, embodiments of the present invention are not limited thereto.

A peripheral device 50 electrically connects the fuel cell stack 30 to a load 62. The peripheral device 50 includes a voltage sensor 52, a current sensor 53, and converter 51. The voltage sensor 52 measures the voltage (or output voltage) of the fuel cell stack 30, and the current sensor 53 measures the current (or output current) of the fuel cell stack. Further, the converter 51 serves to correct the output voltage and output current so that the voltage and current of power generated from the fuel cell stack 30 can be used in the load. The converter 51 is connected to the load 62 to supply power to the load 62. The fuel cell system 101 also includes a controller 40 for controlling the operation of the first fuel pump 14 in accordance with the measured voltage and current.

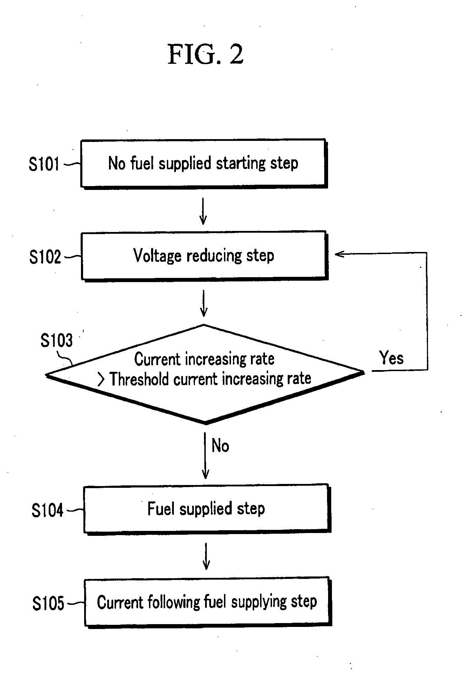

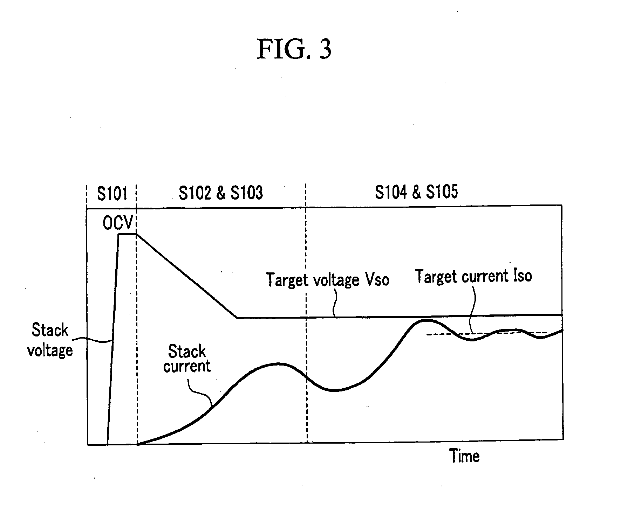

FIG. 2 is a flowchart showing an operating method of a fuel cell system according to the first embodiment of the present invention, and FIG. 3 is a graph of voltage and current against time in accordance with the method of operating a fuel cell system shown in FIG. 2.

An operating method of a fuel cell system according to the present embodiment will be described with reference to FIGS. 2 and 3.

The operating method of the fuel cell system 101 according to the present embodiment includes an starting step without supplying fuel (S101), a voltage reducing step (S102), a current increase rate measuring step (S103), a fuel supplied step (S104), and a current following fuel supplying step (S105).

At the operation starting step without supplying fuel (S101), the fuel cell system 101 starts its operation by connecting a converter 51 to the fuel cell stack 30 in the state where the supply of fuel stops at the time of starting the operation of the fuel cell system 101. At this time, the fuel cell system 101 is operated at a constant voltage until open circuit voltage (OCV) is stable. When the open circuit voltage is stable, output voltage lowers at a constant speed until it reaches targeted voltage (Vₛₒ). When the output voltage is lowered, current is increased, such that current is increased and then reduced, not being continuously increased. The reason is that fuel remaining in the fuel cell stack 30 is exhausted for electricity generation. It may be considered that the time when current starts to reduce is the time when fuel concentration in the fuel cell stack 30 is minimized.

The current increase rate measuring step (S103) measures the increase speed in current to determine whether the increase rate of current is smaller than a targeted increase rate (Iᵣₛₒ). The fuel supplied step (S104) starts the supply of fuel to the fuel cell stack 30 when the increase rate of current is smaller than the targeted increase rate (Iᵣₛₒ). At this time, the targeted increase rate of current may be set to 0 A/s to -0.5 A/s.

Meanwhile, at the current following fuel supplying step (S105), after the supply of fuel starts, the fuel concentration is controlled according to the output of current so that the targeted current (Iₛₒ) can be output from the fuel cell stack 30. At this time, the output voltage of the fuel cell stack 30 is constantly fixed to the targeted voltage (Vₛₒ) by the converter. The targeted voltage (Vₛₒ) and the targeted current (Iₛₒ) can be variously set according to the types of the fuel cell system. For example, in the case of the fuel cell system whose rated output is 30w, the targeted voltage may be set to 1.5V and the targeted current may be set to 40A and in the case of the fuel cell system whose rated output is 300W, the targeted voltage may be set to 6V and the targeted current may be set to 50A.

The current following fuel supplying step (S105) includes repeatedly supplying and stopping the supply of fuel to the mixer 16. In the first exemplary embodiment, a first fuel pump 14, which may be a low precision pump, is used and the supplying of fuel and the stopping the supply of fuel are performed during a period (e.g., a predetermined period in which the supplying of fuel is performed during a first period and stopping the supply of fuel is performed during a second period), which can obtain the same effect as supplying a uniform (or constant) amount of fuel for the entire period. For example, when it is desired to supply 1/10 of the maximum amount of fuel that can be supplied by the first fuel pump 14, the first fuel pump supplies fuel for 1/10 of the period (e.g., where the first period is 1/10 time units long) and stops the supply of fuel for 9/10 of the period (e.g., where the second period is 9/10 time units long), thereby making it possible to obtain the desired precision (e.g., to supply the desired amount of fuel). The fuel introduced into the mixer 16 is sufficiently mixed with water and then introduced into the fuel cell, thereby making it possible to secure a uniform (or stable) concentration.

As described above, the output voltage is fixed to the target voltage (Vₛₒ) and the output current changes according to the fuel concentration, thereby making it possible to minimize or reduce the damage to the fuel cell stack 30. In contrast, if the targeted current (Iₛₒ) is forcibly output by the converter, the reaction is forcibly generated, such that the fuel cell stack 30 may be damaged.

Since the fuel concentration is determined according to the amount of fuel from the fuel tank 12, the controller 40 controls the operation of the first fuel pump 14 in accordance with the measured current, such that the first fuel pump 14 can be controlled by various suitable methods such as proportional (P), proportional-integral (PI), proportional-integral-derivative (PID) control, etc. are widely known in the art and therefore, detailed description thereof will be omitted.

According to the present embodiment, the controller 40 controls the amount of fuel supplied in accordance with the output current to maintain the output current substantially at the target current Iₛₒ without using a concentration sensor and thus, fuel can be supplied more easily. In addition, the high-concentration fuel and water are mixed in the mixer 16 and then supplied to the fuel cell stack 30, such that a low precision pump can be used. When an amount of fuel (e.g., a predetermine amount of fuel) is supplied from the fuel tank 12 to the mixer 16 periodically using the low precision pump by the controller 40 (e.g., a PID controller, etc.), a stable concentration of fuel (e.g., a predetermined concentration of fuel) can be continuously (or stably) supplied.

Meanwhile, at the time of starting the operation, the temperature of the fuel cell stack 30 is low and the electricity generation is not actively made. At this time, when outputting the targeted current by controlling the fuel concentration, the high-concentration fuel is supplied to the fuel cell stack 30, such that the fuel cell stack 30 may be damaged. However, according to the present embodiment, the operation starts without supplying fuel and fuel is supplied in the state where the fuel concentration in the fuel cell stack 30 is minimized, such that the high-concentration fuel is not supplied although fuel is supplied to output the targeted current. In addition, the operation starts by using the fuel remaining in the fuel cell stack 30 and fuel is supplied in the state where the temperature of the fuel cell stack 30 is increased, thereby making it possible to smoothly output the targeted current.

In other words, in some embodiments of the invention, there is a method of controlling a fuel cell system comprising a fuel cell stack, and a controller connected to a load. The method can comprise steps of generating electrical power in the fuel cell stack while not supplying fuel to the fuel cell stack so as to reduce an output voltage of the fuel cell stack and increase an output current of the fuel cell stack (S101, S102). While not supplying fuel to the fuel cell stack, the fuel stack will have some residual fuel that will be exhausted. As the output voltage of the fuel cell stack falls, the current rises.

The step of generating electrical power in the fuel cell stack while not supplying fuel to the fuel cell stack can be continued until the output voltage reaches a target voltage.

The output current of the fuel cell stack is monitored (S103) and the supply of fuel to the fuel stack is started when the output current is above a threshold current or when a rate of increase of the output current is below a threshold rate (S104). In other words, the current is allowed to rise until it reaches a threshold or until the rate of increase of the output current is below a threshold rate.

After the supply of fuel has started, the method comprises controlling supply of fuel controlling supply of fuel to the fuel stack to direct the output current towards a target current level (S105). This is done by maintaining the output voltage to be constant at a target voltage level and periodically starting and stopping the supply of fuel. Hence, will the voltage fixed at the target voltage level, the current will rise as fuel as supplied and will fall as fuel is used up. Hence, periodically starting and stopping the supply of fuel direct the output current towards a target current level (i.e. raises it when the output current falls below the target current level and lowers it when the output current raises above the target current level).

As a result, it can be considered that after the steps of generating electrical power in the fuel cell stack while not supplying fuel to the fuel cell stack so as to reduce an output voltage of the fuel cell stack and increase an output current of the fuel cell stack (S101, S102), the steps of monitoring the output current of the fuel cell stack, starting the supply of fuel to the fuel stack when the output current is above a threshold current or when a rate of increase of the output current is below a threshold rate and controlling supply of fuel to the fuel stack to direct the output current towards a target current level (S103, S104, S105) are repeated. As these steps (S103, S104, S105) are repeated, the voltage can be kept constant, with these steps (S103, S104, S105) acting to direct the output current towards a target current level.

In the above described method concentration sensor is not required because of the steps of generating electrical power in the fuel cell stack while not supplying fuel to the fuel cell stack so as to reduce an output voltage of the fuel cell stack and increase an output current of the fuel cell stack (S101, S102).

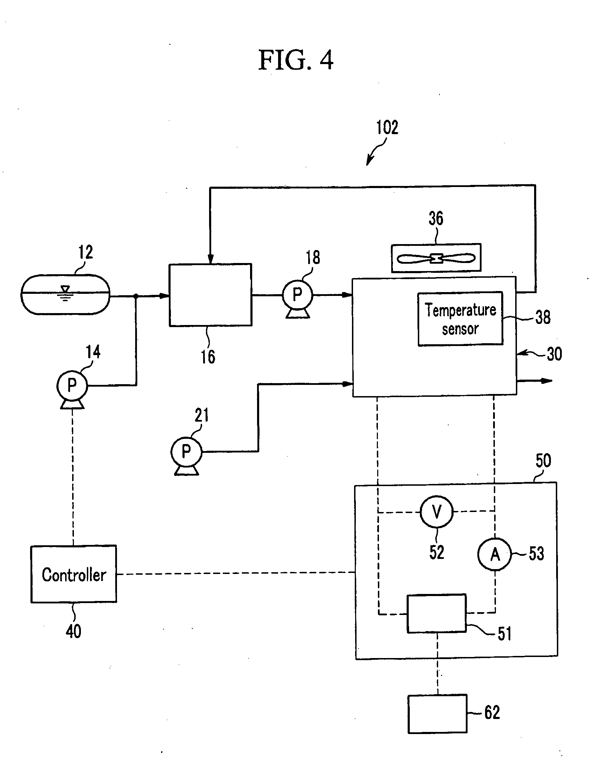

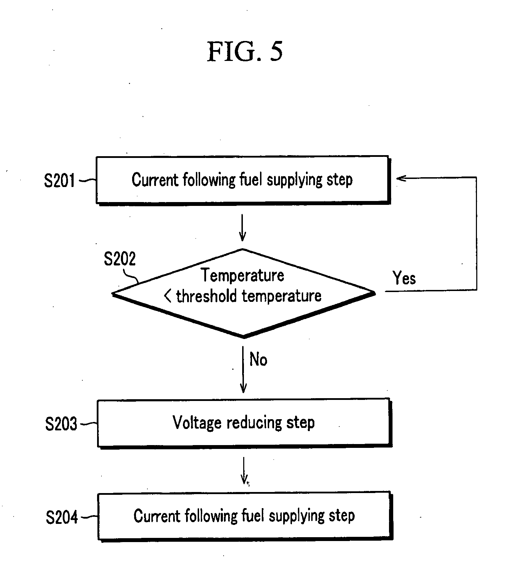

FIG. 4 is a schematic configuration diagram of a fuel cell system according to a second embodiment of the present invention and FIG. 5 is a flowchart showing an operating method of the fuel cell system according to the second embodiment of the present invention.

Referring to FIGS. 4 and 5, a fuel cell system 102 according to the present embodiment further includes a temperature sensor 38 that is installed in the fuel cell stack 30. The fuel cell system 102 has the same configuration as the fuel cell system according to the first embodiment, except for the temperature sensor 38 and therefore, the detailed description thereof will be omitted.

An operating method of the fuel cell system 102 according to the present embodiment includes a current following fuel supplying step (S201) under first targeted voltage, a fuel cell stack temperature measuring step (S202), a voltage reducing step (S203), and a current following fuel supplying step (S204) under second targeted voltage.

The current following fuel supplying step (S201) under the first targeted voltage controls the concentration of fuel to be supplied to the fuel cell stack 30, thereby making it possible to output targeted current (Vso). At this time, the constant voltage (CV) operation that is maintained at the first targeted voltage (Vₛₒ₁) is performed.

Meanwhile, the fuel cell stack temperature measuring step (S202) measures the temperature of the fuel cell stack 30 to determine whether the temperature of the fuel cell stack 30 is higher than a threshold temperature (Tₛₗ). When the fuel cell system 102 is operated for a long time, the performance of the fuel cell stack 30 is deteriorated and thus, the targeted current is not outputted at the first targeted voltage (Vₛₒ₁) condition. In this case, in order to output the targeted current (Iₛₒ), there is the problem in that the high-concentration fuel is supplied to the fuel cell stack 30. When the high-concentration fuel is supplied, excessive heat is generated in the fuel cell stack 30 as well as the fuel cell stack 30 is damaged. In the present embodiment, in order to cool the fuel cell stack 30, a cooling fan 36 is disposed at one side and the cooling fan 36 is set to be rotated at a constant speed. Therefore, the fuel cell stack temperature measuring step (S202) can use the temperature sensor 38 to determine whether the temperature of the fuel cell stack 30 is higher than the threshold temperature (Tₛₗ).

Herein, the threshold temperature (Tₛₗ) is set to temperature higher by 2% to 10% than a reference operating temperature. Since the reference operating temperature is changed according to the types of the fuel cell system, the threshold temperature (Tₛₗ) can be variously set according to the reference operating temperature. The threshold temperature (Tₛₗ) of the direct methanol fuel cell (DMFC) whose reference operating temperature is 62°C may be set to, for example, 63.4°C to 68.2°C.

The voltage reducing step (S203) reduces the target voltage from the first targeted voltage (Vₛₒ₁) to the second targeted voltage (Vₛₒ₂) when the temperature of the fuel cell stack 30 is higher than the threshold temperature(Tₛₗ). When reducing the targeted voltage according to the performance degradation of the fuel cell stack 30, the fuel concentration is not excessively high although the targeted current is output.

The current following fuel supplying step (S204) under the second targeted voltage (Vₛₒ₂) controls the fuel pump to output the targeted current (Iₛₒ) while fixing voltage to the second targeted voltage (Vₛₒ₂).

As described above, according to the present embodiment, even when the performance of the fuel cell stack 30 is deteriorated during a long-time operation, it can stably supply fuel while preventing the fuel concentration from excessively increasing without the concentration sensor.

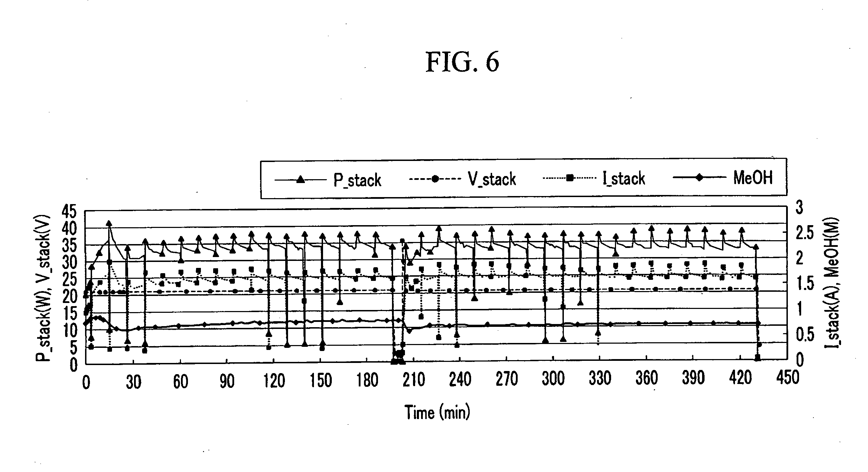

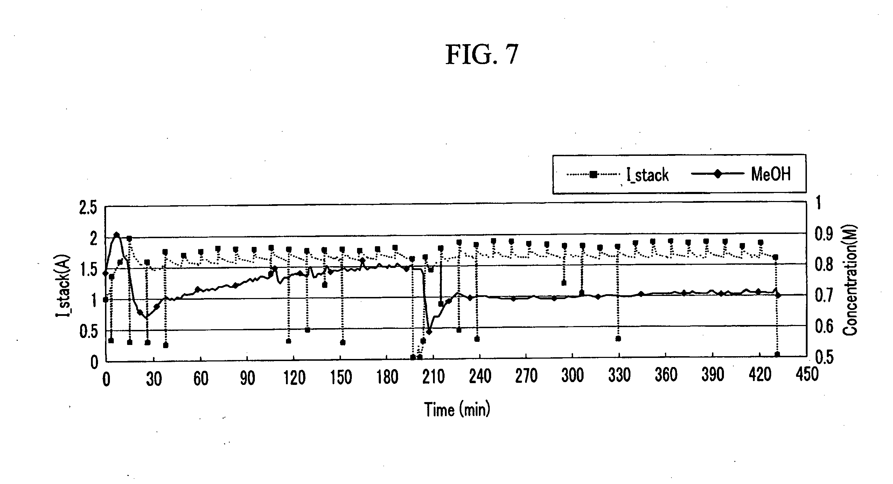

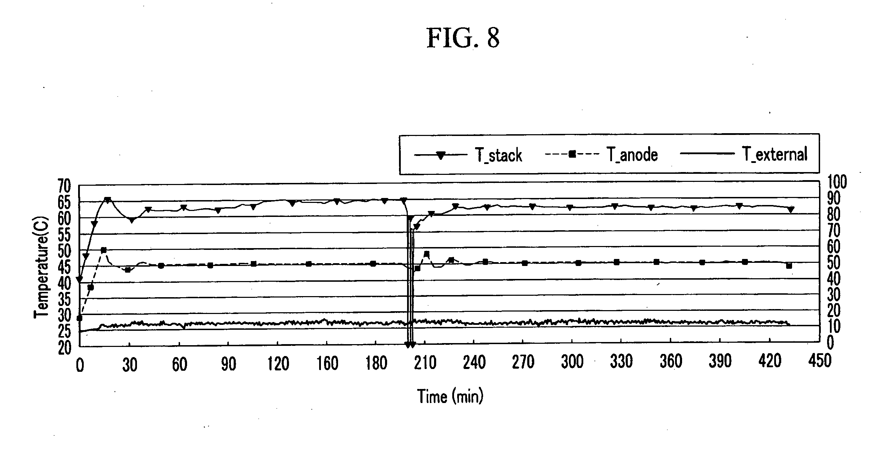

FIG. 6 is a graph showing the voltage, current, power, fuel concentration of the stack according to the operating method of the fuel cell system according to the first embodiment and second embodiment of the present invention, FIG. 7 is a graph showing the current and fuel concentration according to the operating method of the fuel cell system according to the first embodiment and second embodiment of the present invention, and FIG. 8 is a graph showing a stack temperature, an anode temperature, and an external temperature according to the operating method of the fuel cell system according to the first embodiment and second embodiment of the present invention.

Referring to FIGS. 6 to 8, the fuel cell applied to the graph is a fuel cell that has a rated output of 30W, a rated voltage of 20V, and a rated current of 1.5A.

First, as shown in FIG. 7, when the fuel cell system starts, it is operated in the same manner as the first embodiment such that the change in concentration stably appears as 0.63M to 0.9M. In addition, after the fuel cell system starts, it is confirmed that the change in concentration between 240 minutes and 430 minutes stably appears as 0.68M to 0.72M.

As shown in FIG. 6 to FIG. 8, when the operation of the fuel cell system starts and then, approaches about 200 minutes, it can be confirmed that the fuel concentration is increased and the temperature of the fuel cell stack is increased to about 65°C. When the targeted voltage of the fuel cell stack 30 at 200 minutes is lowered from 22 V to 21 V, the fuel concentration is reduced for a while and then, is stably maintained after 230 minutes. At this time, the temperature, value, current, and output of the fuel cell stack 30 are stably maintained.

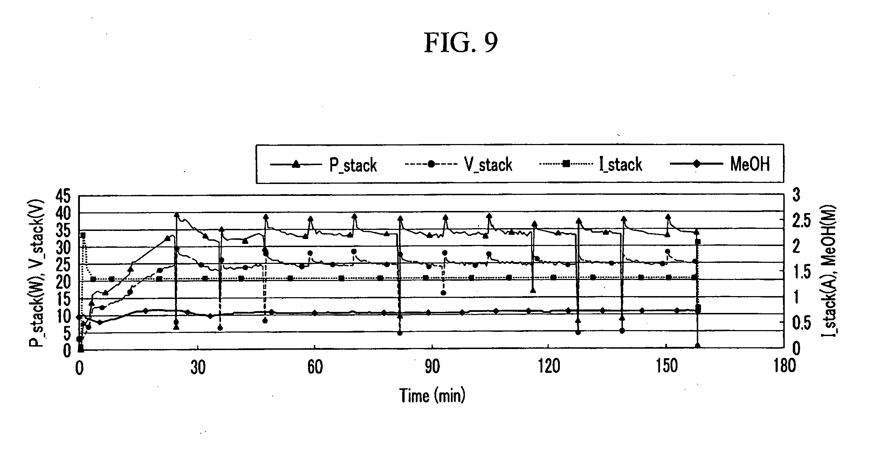

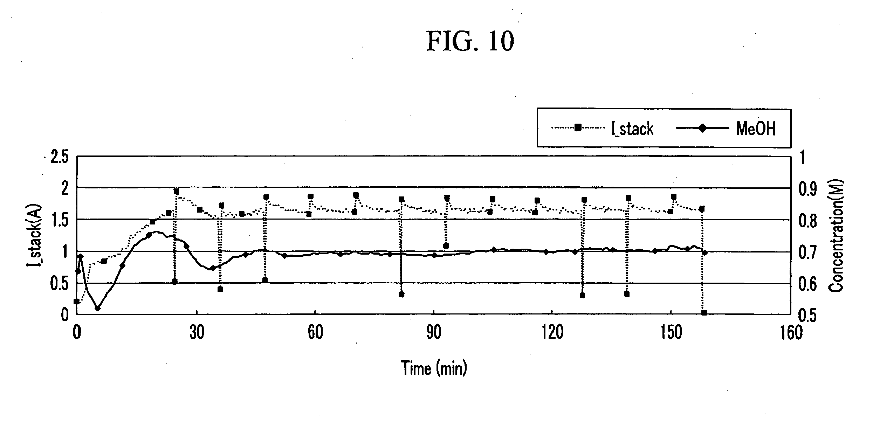

FIG. 9 is a graph showing the power (P_stack), voltage (V_stack), current (I_stack), and fuel (MeOH) concentration of the stack when restarting the operation of the fuel cell system by the methods of operation according to the first and second exemplary embodiments of the present invention and FIG. 10 is a graph showing the current (I_stack) and fuel concentration (MeOH) of the stack when restarting the operation of the fuel cell system by the methods of operation according to the first and second exemplary embodiments of the present invention.

FIGS. 9 and 10 show when the operation of the fuel cell system restarts in the state of lowering the targeted voltage of the fuel cell system. As shown in FIGS. 8 and 9, after the fuel cell system starts and 30 minutes elapses, it can be confirmed that the supplied fuel concentration is in a stable state and the current and power are stably output.

As described above, according to the first embodiment and the second embodiment, when the fuel cell system starts and while the fuel cell system is operated, it can supply fuel with stable concentration according to the targeted current without the concentration sensor.

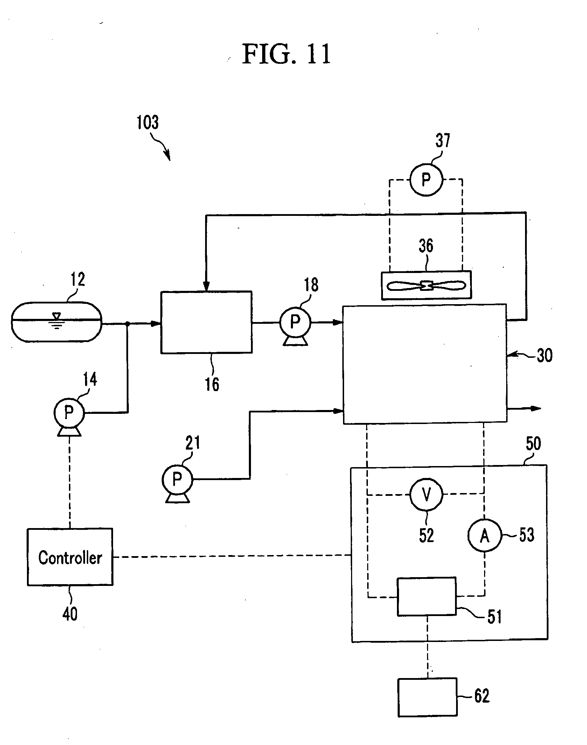

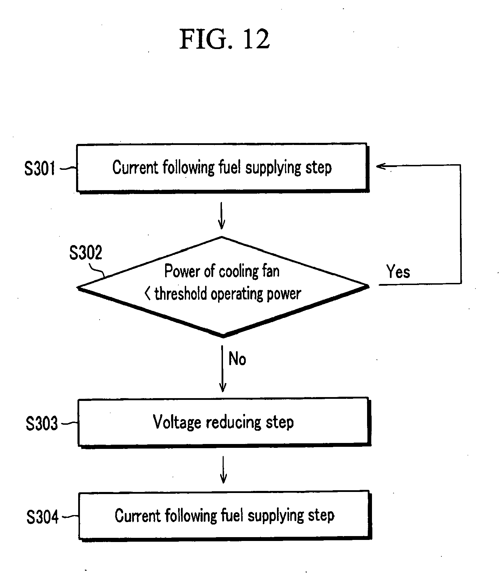

FIG. 11 is a schematic configuration diagram of the fuel cell system according to a third embodiment of the present invention and FIG. 12 is a flowchart for explaining the operating method of the fuel cell system according to the third embodiment of the present invention.

Referring to FIGS. 11 and 12, a fuel cell system 103 according to the present embodiment further includes a power sensor 37 that measures operating voltage of the cooling fan 36. The fuel cell system has the same configuration as the fuel cell system according to the first embodiment, except for the power sensor 37 and therefore, the description of the same components will be omitted.

An operating method of the fuel cell system 103 according to the present embodiment includes a current following fuel supplying step (S301) under first targeted voltage (Vₛₒ₁), a step of measuring operating power (P_{f}) of a cooling fan 36 (S302), a voltage reducing step (S303), and a current following fuel supplying step (S304) under second targeted voltage (Vₛₒ₂).

The current following fuel supplying step (S301) under the first targeted voltage (Vₛₒ₁) controls the fuel concentration to be supplied to the fuel cell stack 30, in order to output targeted current. At this time, voltage is constantly maintained at the first targeted voltage (Vₛₒ₁).

Meanwhile, the step (S302) of measuring the operating power (P_{f}) of the cooling fan 36 measures the operating power (P_{f}) of the cooling fan 36 by the power sensor 37 to determine whether the operating power (P_{f}) of the cooling fan 36 is higher than the threshold power (P_{fl}).

When the fuel cell system 103 is operated for a long time, the performance of the fuel cell stack 30 is deteriorated and thus, the targeted current is not outputted at the first targeted voltage (Vₛₒ₁) condition. In this case, in order to output the targeted current (Iₛₒ), there is the problem in that the high-concentration fuel is supplied to the fuel cell stack 30. When the high-concentration fuel is supplied, excessive heat is generated in the fuel cell stack 30 as well as the fuel cell stack 30 is damaged.

In the present embodiment, when the temperature in the fuel cell stack 30 is increased so that the fuel cell stack 30 can maintain a predetermined temperature, the rotating speed of the cooling fan 36 is set to be increased. Therefore, when excessive heat is generated in the fuel cell stack 30, the rotating speed of the cooling fan 36 is increased to increase the operating power (P_{f}) of the cooling fan 36 and to determine whether the operating power (P_{f}) of the cooling fan 36 is higher than the threshold operating power (P_{fl}).

Herein, the threshold operating power (P_{fl}) is set to power higher by 5% to 20% than a reference operating power. Since the reference operating power is changed according to the sizes of the fuel cell system, the threshold operating power (P_{fl}) can be variously set according to the reference operating voltage. When the reference operating power is 70% of the maximum use power, the threshold driving power (P_{fl}) is 73.5% to 84% of the maximum use power.

The voltage reducing step (S303) reduces the target voltage from the first targeted voltage (Vₛₒ₁) to the second targeted voltage (Vₛₒ₂) when the operating power (P_{f}) of the cooling fan 36 is higher than the threshold temperature (P_{fl}). When reducing the targeted voltage according to the performance degradation of the fuel cell stack 30, the fuel concentration is not excessively high although the targeted current is output.

The current following fuel supplying step (S304) under the second targeted voltage (Vₛₒ₂) controls the fuel pump to output the targeted current (Iₛₒ) while fixing voltage to the second targeted voltage (Vₛₒ₂).

In other embodiments, there is provided a method of controlling a fuel cell system comprising a fuel cell stack, the method comprising: controlling supply of fuel to the fuel cell stack to direct an output current of the fuel cell stack towards a target current level, while maintaining an output voltage of the fuel cell stack to be constant at a first target voltage level; measuring the temperature of the fuel cell stack to determine whether the temperature of the fuel cell stack is higher than a threshold temperature; when the temperature of the fuel cell stack is higher than the threshold temperature, reducing the target voltage level from the first target voltage level to a second target voltage level; controlling the supply of fuel to the fuel cell stack to direct the output current towards the target current level, while maintaining the output voltage of the fuel cell stack to be constant at the second target voltage level. The method may comprise controlling the supply of fuel to the fuel stack by the controller by periodically starting and stopping the supply of fuel to the fuel cell stack to direct the output current towards the target current level.

In other embodiments, there is provided a method of controlling a fuel cell system comprising a fuel cell stack and a cooling fan adapted to cool the fuel cell stack, the method comprising: controlling supply of fuel to the fuel cell stack to direct an output current of the fuel cell stack towards a target current level, while maintaining an output voltage of the fuel cell stack to be constant at a first target voltage level; measuring an operating power of the cooling fan to determine whether the operating power of the cooling fan is higher than a threshold power; when the operating power of the cooling fan is higher than the threshold power, reducing the target voltage level from the first target voltage level to a second target voltage level; controlling the supply of fuel to the fuel cell stack to direct the output current towards the target current level, while maintaining the output voltage of the fuel cell stack to be constant at the second target voltage level. The method may comprise controlling the supply of fuel to the fuel stack by the controller by periodically starting and stopping the supply of fuel to the fuel cell stack to direct the output current towards the target current level.

In other embodiments, there is provided a method of controlling a fuel cell system comprising a fuel cell stack, the method comprising: periodically starting and stopping supply of fuel to the fuel cell stack to direct an output current of the fuel cell stack towards a target current level, while maintaining an output voltage of the fuel cell stack to be constant at a target voltage level,

As described above, according to the present embodiment, even though the performance of the fuel cell stack 30 is degraded due to the long-time operation, it can stably supply fuel while preventing the fuel concentration from excessively increasing.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A fuel cell system (101) comprising a fuel tank (12), a fuel cell stack (30) and a controller (40), wherein:
the fuel cell system (101) is arranged to generate electrical power in the fuel cell stack (30) while not supplying fuel from the fuel tank (12) to the fuel cell stack (30) so as to reduce an output voltage of the fuel cell stack (30) and increase an output current of the fuel cell stack (30);
the controller (40) is arranged to monitor the output current of the fuel cell stack (30);
the controller (40) is arranged to start the supply of fuel from the fuel tank (12) to the fuel cell stack (30) when the output current is above a threshold current or when a rate of increase of the output current is below a threshold rate; and
the controller (40) is arranged to control the supply of fuel from the fuel tank (12) to the fuel cell stack (30) to direct the output current towards a target current level.

2. A fuel cell system according to Claim 1, wherein controlling supply of fuel to the fuel cell stack (30) by the controller (40) comprises periodically starting and stopping the supply of fuel to the fuel cell stack (30).

3. A fuel cell system according to Claim 1 or 2, wherein the fuel cell system (101) is arranged to continue generating electrical power in the fuel cell stack (30) while not supplying fuel to the fuel cell stack (30) until the output voltage reaches a target voltage.

4. A fuel cell system according to any one of Claims 1 to 3, wherein the supply of fuel to the fuel cell stack (30) is started when a rate of increase of the output current is below the threshold rate, the threshold rate being between 0 A/s and -0.5 A/s.

5. A fuel cell system according to any one of Claims 1 to 4, wherein the controller (40) is arranged to control the supply of fuel to the fuel cell stack (30) while maintaining the output voltage to be constant at a target voltage level.

6. A fuel cell system according to Claim 5, further comprising:
a temperature sensor arranged to measure the temperature of the fuel cell stack (30) to determine whether the temperature of the fuel cell stack is higher than a threshold temperature;
when the temperature of the fuel cell stack (30) is higher than the threshold temperature, the controller (40) is arranged to reduce the target voltage level to a second target voltage level and then to control the supply of fuel to the fuel cell stack (30) to direct the output current towards the target current level, while maintaining the output voltage of the fuel cell stack (30) to be constant at the second target voltage level.

7. A fuel cell system according to Claim 6, wherein the threshold temperature is between 2% and 10% greater than a reference operating temperature.

8. A fuel cell system according to Claim 5, wherein the fuel cell system (101) comprises a cooling fan (36) adapted to cool the fuel cell stack (30);
wherein the fuel cell system (101) is arranged to measure an operating power of the cooling fan (36) to determine whether the operating power of the cooling fan (36) is higher than a threshold power;
when the operating power of the cooling fan (36) is higher than the threshold power, the controller (40) is arranged to reduce the target voltage level to a second target voltage level and then to control the supply of fuel to the fuel cell stack (30) to direct the output current towards the target current level, while maintaining the output voltage of the fuel cell stack (30) to be constant at the second target voltage level.

9. A fuel cell system according to Claim 8, wherein the threshold power is set to be a power higher by 5% to 20% than a reference operating power, wherein optionally the reference operating power is 70% of a maximum use power of the fan.

10. A method of controlling a fuel cell system (101) comprising a fuel cell stack (30), and a controller (40) connected to a load (62), the method comprising in order:
generating electrical power in the fuel cell stack (30) while not supplying fuel to the fuel cell stack (30) so as to reduce an output voltage of the fuel cell stack and increase an output current of the fuel cell stack;
monitoring the output current of the fuel cell stack (30);
starting the supply of fuel to the fuel cell stack (30) when the output current is above a threshold current or when a rate of increase of the output current is below a threshold rate; and
controlling supply of fuel to the fuel cell stack (30) to direct the output current towards a target current level.

11. A method of controlling a fuel cell system according to Claim 10, wherein controlling supply of fuel to the fuel cell stack (30) comprises periodically starting and stopping the supply of fuel.

12. A method of controlling a fuel cell system according to Claim 10 or 11, wherein generating electrical power in the fuel cell stack (30) while not supplying fuel to the fuel cell stack (30) is continued until the output voltage reaches a target voltage.

13. A method of controlling a fuel cell system according to any one of Claims 10 to 12, wherein controlling supply of fuel to the fuel cell stack (30) is carried out while maintaining the output voltage to be constant at a target voltage level

14. A method of controlling a fuel cell system according to Claim 13, further comprising:
measuring the temperature of the fuel cell stack (30) to determine whether the temperature of the fuel cell stack is higher than a threshold temperature;
when the temperature of the fuel cell stack (30) is higher than the threshold temperature, reducing the target voltage level to a second target voltage level;
controlling the supply of fuel to the fuel cell stack (30) to direct the output current towards the target current level, while maintaining the output voltage of the fuel cell stack (30) to be constant at the second target voltage level.

15. A method of controlling a fuel cell system according to Claim 13, wherein the fuel cell system (101) comprises a cooling fan (36) adapted to cool the fuel cell stack, the method further comprising:
measuring an operating power of the cooling fan (36) to determine whether the operating power of the cooling fan is higher than a threshold power;
when the operating power of the cooling fan (36) is higher than the threshold power, reducing the target voltage level to a second target voltage level;
controlling the supply of fuel to the fuel cell stack (30) to direct the output current towards the target current level, while maintaining the output voltage of the fuel cell stack to be constant at the second target voltage level.

## Patentansprüche

1. Brennstoffzellensystem (101) umfassend einen Brennstoffbehälter (12), einen Brennstoffzellenstapel (30) und eine Steuerung (40), wobei:
das Brennstoffzellensystem (101) angeordnet ist, elektrische Leistung in dem Brennstoffzellenstapel (30) zu erzeugen, während dem Brennstoffzellenstapel (30) kein Brennstoff aus dem Brennstoffbehälter (12) zugeführt wird, um eine Ausgangsspannung des Brennstoffzellenstapels (30) zu verringern und einen Ausgangsstrom des Brennstoffzellenstapels (30) zu erhöhen;
die Steuerung (40) angeordnet ist, den Ausgangsstrom des Brennstoffzellenstapels (30) zu überwachen;
die Steuerung (40) angeordnet ist, die Brennstoffzufuhr aus dem Brennstoffbehälter (12) zu dem Brennstoffzellenstapel (30) zu starten, wenn der Ausgangsstrom über einem Schwellenstrom liegt oder wenn eine Erhöhungsgeschwindigkeit des Ausgangsstroms unter einer Schwellengeschwindigkeit liegt; und
die Steuerung (40) angeordnet ist, die Brennstoffzufuhr aus dem Brennstoffbehälter (12) zu dem Brennstoffzellenstapel (30) zu steuern, um den Ausgangsstrom in Richtung eines Soll-Strompegels zu lenken.

2. Brennstoffzellensystem nach Anspruch 1, wobei das Steuern der Brennstoffzufuhr zu dem Brennstoffzellenstapel (30) durch die Steuerung (40) das periodische Starten und Stoppen der Brennstoffzufuhr zu dem Brennstoffzellenstapel (30) umfasst.

3. Brennstoffzellensystem nach Anspruch 1 oder 2, wobei das Brennstoffzellensystem (101) angeordnet ist, die Erzeugung elektrischer Leistung in dem Brennstoffzellenstapel (30) fortzusetzen, während dem Brennstoffzellenstapel (30) kein Brennstoff zugeführt wird, bis die Ausgangsspannung eine Sollspannung erreicht.

4. Brennstoffzellensystem nach einem der Ansprüche 1 bis 3, wobei die Brennstoffzufuhr zu dem Brennstoffzellenstapel (30) gestartet wird, wenn eine Erhöhungsgeschwindigkeit des Ausgangsstroms unter der Schwellengeschwindigkeit liegt, wobei die Schwellengeschwindigkeit zwischen 0 A/s und -0,5 A/s liegt.

5. Brennstoffzellensystem nach einem der Ansprüche 1 bis 4, wobei die Steuerung angeordnet ist, die Brennstoffzufuhr zu dem Brennstoffzellenstapel (30) zu steuern, während die Ausgangsspannung konstant auf einem Soll-Spannungspegel gehalten wird.

6. Brennstoffzellensystem nach Anspruch 5, ferner umfassend:
einen Temperatursensor, der angeordnet ist, die Temperatur des Brennstoffzellenstapels (30) zu messen, um zu bestimmen, ob die Temperatur des Brennstoffzellenstapels höher ist als eine Schwellentemperatur;
wenn die Temperatur des Brennstoffzellenstapels (30) höher ist als die Schwellentemperatur, die Steuerung (40) angeordnet ist, den Soll-Spannungspegel auf einen zweiten Soll-Spannungspegel zu verringern und die Brennstoffzufuhr zu dem Brennstoffzellenstapel (30) dann derart zu steuern, dass der Ausgangsstrom in Richtung des Soll-Strompegels gelenkt wird, während die Ausgangsspannung des Brennstoffzellenstapels (30) konstant auf dem zweiten Soll-Spannungspegel gehalten wird.

7. Brennstoffzellensystem nach Anspruch 6, wobei die Schwellentemperatur zwischen 2% und 10 % größer ist als eine Referenzbetriebstemperatur.

8. Brennstoffzellensystem nach Anspruch 5, wobei das Brennstoffzellensystem (101) ein Kühlgebläse (36) umfasst, das zum Kühlen des Brennstoffzellenstapels (30) ausgebildet ist;
wobei das Brennstoffzellensystem (101) angeordnet ist, eine Betriebsleistung des Kühlgebläses (36) zu messen, um zu bestimmen, ob die Betriebsleistung des Kühlgebläses (36) höher ist als eine Schwellenleistung;
wenn die Betriebsleistung des Kühlgebläses (36) höher ist als die Schwellenleistung, die Steuerung (40) angeordnet ist, den Soll-Spannungspegel auf einen zweiten Soll-Spannungspegel zu verringern und die Brennstoffzufuhr zu dem Brennstoffzellenstapel (30) dann derart zu steuern, dass der Ausgangsstrom in Richtung des Soll-Strompegels gelenkt wird, während die Ausgangsspannung des Brennstoffzellenstapels (30) konstant auf dem zweiten Soll-Spannungspegel gehalten wird.

9. Brennstoffzellensystem nach Anspruch 8, wobei die Schwellenleistung auf eine Leistung eingestellt ist, die um 5% bis 20% höher ist als eine Referenzbetriebsleistung, wobei die Referenzbetriebsleistung optional 70% einer maximalen Nutzungsleistung des Gebläses beträgt.

10. Verfahren zum Steuern eines Brennstoffzellensystems (101) umfassend einen Brennstoffzellenstapel (30) sowie eine mit einer Last (62) verbundene Steuerung (40), wobei das Verfahren der Reihe nach umfasst:
Erzeugen elektrischer Leistung in dem Brennstoffzellenstapel (30), während dem Brennstoffzellenstapel (30) kein Brennstoff zugeführt wird, um eine Ausgangsspannung des Brennstoffzellenstapels zu verringern und einen Ausgangsstrom des Brennstoffzellenstapels zu erhöhen;
Überwachen des Ausgangsstroms des Brennstoffzellenstapels (30);
Starten der Brennstoffzufuhr zu dem Brennstoffzellenstapel (30), wenn der Ausgangsstrom über einem Schwellenstrom liegt oder wenn eine Erhöhungsgeschwindigkeit des Ausgangsstroms unter einer Schwellengeschwindigkeit liegt; und
Steuern der Brennstoffzufuhr zu dem Brennstoffzellenstapel (30), um den Ausgangsstrom in Richtung eines Soll-Strompegels zu lenken.

11. Verfahren zum Steuern eines Brennstoffzellensystems nach Anspruch 10, wobei das Steuern der Brennstoffzufuhr zu dem Brennstoffzellenstapel (30) das periodische Starten und Stoppen der Brennstoffzufuhr umfasst.

12. Verfahren zum Steuern eines Brennstoffzellensystems nach Anspruch 10 oder 11, wobei die Erzeugung elektrischer Leistung in dem Brennstoffzellenstapel (30) fortgesetzt wird, während dem Brennstoffzellenstapel (30) kein Brennstoff zugeführt wird, bis die Ausgangsspannung eine Sollspannung erreicht.

13. Verfahren zum Steuern eines Brennstoffzellensystems nach einem der Ansprüche 10 bis 12, wobei das Steuern der Brennstoffzufuhr zu dem Brennstoffzellenstapel (30) ausgeführt wird, während die Ausgangsspannung konstant auf einem Soll-Spannungspegel gehalten wird.

14. Verfahren zum Steuern eines Brennstoffzellensystems nach Anspruch 13, ferner umfassend:
Messen der Temperatur des Brennstoffzellenstapels (30), um zu bestimmen, ob die Temperatur des Brennstoffzellenstapels höher als eine Schwellentemperatur ist;
wenn die Temperatur des Brennstoffzellenstapels (30) höher ist als die Schwellentemperatur, Verringern des Soll-Spannungspegels auf einen zweiten Soll-Spannungspegel,
Steuern der Brennstoffzufuhr zu dem Brennstoffzellenstapel (30), um den Ausgangsstrom in Richtung des Soll-Strompegels zu lenken, während die Ausgangsspannung des Brennstoffzellenstapels (30) konstant auf dem zweiten Soll-Spannungspegel gehalten wird.

15. Verfahren zum Steuern eines Brennstoffzellensystems nach Anspruch 13, wobei das Brennstoffzellensystem (101) ein Kühlgebläse (36) umfasst, das zum Kühlen des Brennstoffzellenstapels (30) ausgebildet ist, wobei das Verfahren ferner umfasst:
Messen einer Betriebsleistung des Kühlgebläses (36), um zu bestimmen, ob die Betriebsleistung des Kühlgebläses höher ist als eine Schwellenleistung;
wenn die Betriebsleistung des Kühlgebläses (36) höher ist als die Schwellenleistung, Verringern des Soll-Spannungspegels auf einen zweiten Soll-Spannungspegel;
Steuern der Brennstoffzufuhr zu dem Brennstoffzellenstapel (30), um den Ausgangsstrom in Richtung des Soll-Strompegels zu lenken, während die Ausgangsspannung des Brennstoffzellenstapels konstant auf dem zweiten Soll-Spannungspegel gehalten wird.

## Revendications

1. Système de pile à combustible (101), comprenant un réservoir de carburant (12), un empilement de piles à combustible (30), et un dispositif de commande (40), dans lequel :
le système de pile à combustible (101) est configuré de façon à générer de l'énergie électrique dans l'empilement de piles à combustible (30), tout en ne délivrant pas de carburant du réservoir de carburant (12) à l'empilement de piles à combustible (30), de façon à réduire une tension de sortie de l'empilement de piles à combustible (30) et à augmenter un courant de sortie de l'empilement de piles à combustible (30) ;
le dispositif de commande (40) est configuré de façon à contrôler le courant de sortie de l'empilement de piles à combustible (30) ;
le dispositif de commande (40) est configuré de façon à démarrer la délivrance de carburant du réservoir de carburant (12) à l'empilement de piles à combustible (30) lorsque le courant de sortie est supérieur à un courant de seuil ou lorsqu'un taux d'augmentation du courant de sortie est inférieur à un taux de seuil ; et
le dispositif de commande (40) est configuré de façon à commander la délivrance de carburant du réservoir de carburant (12) à l'empilement de piles à combustible (30) de façon à diriger le courant de sortie vers un niveau de courant cible.

2. Système de pile à combustible selon la revendication 1, dans lequel la commande de la délivrance de carburant à l'empilement de piles à combustible (30) par le dispositif de commande (40) comprend le démarrage et l'arrêt périodiques de la délivrance de carburant à l'empilement de piles à combustible (30).

3. Système de pile à combustible selon la revendication 1 ou 2, dans lequel le système de pile à combustible (101) est configuré de façon à poursuivre la génération d'énergie électrique dans l'empilement de piles à combustible (30) tout en ne délivrant pas de carburant à l'empilement de piles à combustible (30) jusqu'à ce que la tension de sortie atteigne une tension cible.

4. Système de pile à combustible selon l'une quelconque des revendications 1 à 3, dans lequel la délivrance de carburant à l'empilement de piles à combustible (30) est démarrée quand un taux d'augmentation du courant de sortie est inférieur au taux de seuil, le taux de seuil étant compris entre 0 A/s et -0,5 A/s.

5. Système de pile à combustible selon l'une quelconque des revendications 1 à 4, dans lequel le dispositif de commande (40) est configuré de façon à commander la délivrance de carburant à l'empilement de piles à combustible (30) tout en maintenant la tension de sortie de telle sorte qu'elle soit constante à un niveau de tension cible.

6. Système de pile à combustible selon la revendication 5, comprenant de plus :
un capteur de température configuré de façon à mesurer la température de l'empilement de piles à combustible (30) afin de déterminer si la température de l'empilement de piles à combustible est ou non supérieure à une température de seuil ;
lorsque la température de l'empilement de piles à combustible (30) est supérieure à la température de seuil, le dispositif de commande (40) étant configuré de façon à réduire le niveau de tension cible à un deuxième niveau de tension cible, puis à commander la délivrance de carburant à l'empilement de piles à combustible (30) afin de diriger le courant de sortie vers le niveau de courant cible, tout en maintenant la tension de sortie de l'empilement de piles à combustible (30) de telle sorte qu'elle soit constante au deuxième niveau de tension cible.

7. Système de pile à combustible selon la revendication 6, dans lequel la température de seuil est entre 2% et 10% supérieure à une température de fonctionnement de référence.

8. Système de pile à combustible selon la revendication 5, dans lequel le système de pile à combustible (101) comprend un ventilateur de refroidissement (36) adapté de façon à refroidir l'empilement de piles à combustible (30) ;
dans lequel le système de pile à combustible (101) est configuré de façon à mesurer une puissance de fonctionnement du ventilateur de refroidissement (36) afin de déterminer si la puissance de fonctionnement du ventilateur de refroidissement (36) est ou non supérieure à une puissance de seuil ;
lorsque la puissance de fonctionnement du ventilateur de refroidissement (36) est supérieure à la puissance de seuil, le dispositif de commande (40) étant configuré de façon à réduire le niveau de tension cible à un deuxième niveau de tension cible, puis à commander la délivrance de carburant à l'empilement de piles à combustible (30) afin de diriger le courant de sortie vers le niveau de courant cible, tout en maintenant la tension de sortie de l'empilement de piles à combustible (30) de telle sorte qu'elle soit constante au deuxième niveau de tension cible.

9. Système de pile à combustible selon la revendication 8, dans lequel la puissance de seuil est établie de façon à être une puissance supérieure de 5% à 20% à une puissance de fonctionnement de référence, dans lequel, de façon optionnelle, la puissance de fonctionnement de référence est de 70% d'une puissance d'utilisation maximale du ventilateur.

10. Procédé de commande d'un système de pile à combustible (101) comprenant un empilement de piles à combustible (30), et un dispositif de commande (40) connecté à une charge (62), le procédé comprenant, dans l'ordre :
la génération d'une énergie électrique dans l'empilement de piles à combustible (30), tout en ne délivrant pas de carburant à l'empilement de piles à combustible (30), de façon à réduire une tension de sortie de l'empilement de piles à combustible et à augmenter un courant de sortie de l'empilement de piles à combustible ;
le contrôle du courant de sortie de l'empilement de piles à combustible (30) ;
le démarrage de la délivrance de carburant à l'empilement de piles à combustible (30) lorsque le courant de sortie est supérieur à un courant de seuil ou lorsqu'un taux d'augmentation du courant de sortie est inférieur à un taux de seuil ; et
la commande de la délivrance de carburant à l'empilement de piles à combustible (30) de façon à diriger le courant de sortie vers un niveau de courant cible.

11. Procédé de commande d'un système de pile à combustible selon la revendication 10, dans lequel la commande de la délivrance de carburant à l'empilement de piles à combustible (30) comprend le démarrage et l'arrêt périodiques de la délivrance de carburant.

12. Procédé de commande d'un système de pile à combustible selon la revendication 10 ou 11, dans lequel la génération d'énergie électrique dans l'empilement de piles à combustible (30) tout en ne délivrant pas de carburant à l'empilement de piles à combustible (30) est poursuivie jusqu'à ce que la tension de sortie atteigne une tension cible.

13. Procédé de commande d'un système de pile à combustible selon l'une quelconque des revendications 10 à 12, dans lequel la commande de la délivrance de carburant à l'empilement de piles à combustible (30) est effectuée tout en maintenant la tension de sortie de telle sorte qu'elle soit constante à un niveau de tension cible.

14. Procédé de commande d'un système de pile à combustible selon la revendication 13, comprenant de plus :
la mesure de la température de l'empilement de piles à combustible (30) de façon à déterminer si la température de l'empilement de piles à combustible est ou non supérieure à une température de seuil ;
lorsque la température de l'empilement de piles à combustible (30) est supérieure à la température de seuil, la réduction du niveau de tension cible à un deuxième niveau de tension cible ;
la commande de la délivrance de carburant à l'empilement de piles à combustible (30) de façon à diriger le courant de sortie vers le niveau de courant cible, tout en maintenant la tension de sortie de l'empilement de piles à combustible (30) de telle sorte qu'elle soit constante au deuxième niveau de tension cible.

15. Procédé de commande d'un système de pile à combustible selon la revendication 13, dans lequel le système de pile à combustible (101) comprend un ventilateur de refroidissement (36) adapté de façon à refroidir l'empilement de piles à combustible, le procédé comprenant de plus :
la mesure d'une puissance de fonctionnement du ventilateur de refroidissement (36) de façon à déterminer si la puissance de fonctionnement du ventilateur de refroidissement est ou non supérieure à une puissance de seuil ;
lorsque la puissance de fonctionnement du ventilateur de refroidissement (36) est supérieure à la puissance de seuil, la réduction du niveau de tension cible à un deuxième niveau de tension cible ;
la commande de la délivrance de carburant à l'empilement de piles à combustible (30) de façon à diriger le courant de sortie vers le niveau de courant cible, tout en maintenant la tension de sortie de l'empilement de piles à combustible de telle sorte qu'elle soit constante au deuxième niveau de tension cible.
